(19) Europäisches Patentamt / European Patent Office / Office européen des brevets

(11) **EP 1 376 147 B1**

(12) **EUROPÄISCHE PATENTSCHRIFT**

(45) Veröffentlichungstag und Bekanntmachung des Hinweises auf die Patenterteilung:
**29.04.2009   Patentblatt 2009/18**

(51) Int Cl.:
*G01R 33/3815* [(2006.01)]   *G01R 33/421* [(2006.01)]

(21) Anmeldenummer: **03010064.8**

(22) Anmeldetag: **03.05.2003**

(54) **Aktiv abgeschirmte, supraleitende Magnetanordnung mit einer Vorrichtung zur zusätzlichen Streufeldoptimierung**

Actively shielded superconducting magnet arrangement with means for additional stray-field optimization

Assemblage d'aimants supraconducteurs blindé activement avec des moyens supplémentaires de compensation des champs de fuite

(84) Benannte Vertragsstaaten:
**CH DE FR GB LI**

(30) Priorität: **22.06.2002   DE 10227877**

(43) Veröffentlichungstag der Anmeldung:
**02.01.2004   Patentblatt 2004/01**

(73) Patentinhaber: **Bruker BioSpin AG**
**8117 Fällanden (CH)**

(72) Erfinder:
• **Schauwecker, Robert**
**8004 Zürich (CH)**
• **Amann, Andreas**
**8008 Zürich (CH)**
• **Bovier, Pierre-Alain**
**8051 Zürich (CH)**

(74) Vertreter: **Kohler Schmid Möbus**
**Patentanwälte**
**Ruppmannstrasse 27**
**70565 Stuttgart (DE)**

(56) Entgegenhaltungen:
**EP-A- 1 079 236**      **EP-A- 1 182 464**
**EP-A- 1 213 591**

**Beschreibung**

Die Erfindung betrifft eine Magnetanordnung zur Erzeugung eines Magnetfeldes in Richtung einer *z*-Achse in einem auf der *z*-Achse um *z* = 0 angeordneten Arbeitsvolumen mit einem aktiv abgeschirmten, supraleitenden Magnetspulensystem und mit mindestens einem, im Betriebszustand in sich supraleitend geschlossenen Strompfad eines weiteren Magnetspulensystems, wobei das aktiv abgeschirmte, supraleitende Magnetspulensystem ein radial inneres und ein radial äußeres Teilspulensystem umfaßt, welche zueinander koaxial angeordnet sind und deren magnetische Dipolmomente im Betriebszustand entgegengesetzte Vorzeichen aufweisen und sich betragsmäßig um $\Delta_m$ voneinander unterscheiden mit $|\Delta_m|$ < 2.5% des Betrags des magnetischen Dipolmoments des radial inneren Teilspulensystems, und wobei das Magnetfeld der Magnetanordnung auf der *z*-Achse um *z* = 0 in ein Polynom in *z* mit den Koeffizienten *Hn* entwickelt werden kann, und wobei die Magnetanordnung über eine externe Vorrichtung zur Speisung des mindestens einen Strompfades verfügt, so dass im Betriebszustand alle Strompfade mit je einem Betriebsstrom geladen sind, und wobei die Strompfade im Betriebszustand im Arbeitsvolumen der Magnetanordnung insgesamt einen Beitrag zum Magnetfeld der Magnetanordnung leisten, dessen Betrag kleiner ist als 5% des Feldbetrages des aktiv abgeschirmten, supraleitenden Magnetspulensystems im Betriebszustand.

Eine solche Magnetanordnung mit einem aktiv abgeschirmten Magnetspulensystem und mit mindestens einem zusätzlichen, supraleitend geschlossenen Strompfad ist bekannt aus der Patentschrift US 6,265,960. In dieser Magnetanordnung wirkt ein zusätzlicher, supraleitend geschlossener Strompfad als supraleitende Shimvorrichtung zur Verbesserung der Feldhomogenität im Arbeitsvolumen der Magnetanordnung.

Eine weitere Magnetanordnung mit einem aktiv abgeschirmten Magnetspulensystem und mit mindestens einem zusätzlichen, supraleitend geschlossenen Strompfad ist bekannt aus der Patentschrift WO 00/52490. In dieser Magnetanordnung wirkt ein zusätzlicher, supraleitend geschlossener Strompfad als Vorrichtung zur Kompensation von externen elektromagnetischen Störungen, als Vorrichtung zur Kompensation einer vom Magnetspulensystem selbst verursachten Felddrift oder als Vorrichtung zur Feinanpassung der magnetischen Feldstärke im Arbeitsvolumen.

Das Einsatzgebiet von supraleitenden Magneten umfaßt verschiedene Anwendungsfelder. Dazu gehören insbesondere Hochfeldanwendungen, beispielsweise für Magnetresonanzverfahren. Solche Hochfeldmagneten erzeugen typischerweise auch ein beträchtliches Streufeld, was für die Umgebung des Magneten ein Gefahrenpotential darstellt. Diesem Problem kann begegnet werden, indem der Magnet mit einer aktiven Abschirmung ausgerüstet wird, also mit einer zusätzlichen supraleitenden Spule, welche mit der Hauptspule des Magneten in Serie geschaltet ist, aber ein Feld mit entgegengesetzter Polarität erzeugt.

Insbesondere für Magneten mit sehr effizienter Streufeldabschirmung ergibt sich das Problem, dass Abweichungen von den Designvorgaben für die Magnetspulen eine beträchtliche Veränderung des von der Magnetanordnung erzeugten Streufeldes zur Folge haben können, so dass spezifizierte Streufeldgrenzwerte verletzt werden. Geringe Abweichungen von den Designvorgaben aufgrund von Fertigungstoleranzen sind unvermeidbar. Beispielsweise können die Drahtdurchmesser Schwankungen bis zur Größenordnung eines Prozents aufweisen. Dass sich solch kleine Abweichungen in einer dramatischen Verschlechterung der Streufeldwerte auswirken können, rührt daher, dass zur Kompensation des Streufeldes außerhalb der Magnetanordnung große Feldbeiträge mit unterschiedlichem Vorzeichen einander überlagert werden . An einem Ort, wo ein Streufeld von 0.5mT resultieren soll, liegen die sich gegenseitig kompensierenden Beiträge von Hauptspule und Streufeldabschirmung beispielsweise in der Größenordnung von 100mT. Wenn nun einer dieser beiden Feldbeiträge aufgrund der begrenzten Fertigungsgenauigkeit der Spulensysteme um ca. 1% von seinem Sollwert abweicht, führt dies am Ort der 0.5mT-Isofeldfläche zu einer Abweichung der Streufeldstärke von ca. 1 mT vom Sollwert. Das spezifizierte Streufeldlimit an diesem Ort könnte in einem solchen Fall also um ein Mehrfaches überschritten werden.

Aufgabe der vorliegenden Erfindung ist es, eine Magnetanordnung gemäß Stand der Technik derart zu verbessern, dass ihre Streufeldgrenzwerte auch dann eingehalten werden, wenn einzelne Parameter der Spulenanordnung aufgrund der begrenzten Fertigungsgenauigkeit von den Sollwerten abweichen. Hierbei sollen insbesondere die Streufeldauswirkungen von Abweichungen der Wickeldaten vom Sollwert und Abweichungen der Geometrie der Spulenkörper, welche als Träger der einzelnen Spulensysteme dienen, von ihrer Sollgeometrie kompensiert werden.

Erfindungsgemäß wird diese Aufgabe durch die Merkmale des kennzeichnenden Teils von Anspruch 1 gelöst. Insbesondere ist in der Magnetanordnung mindestens ein zusätzlicher supraleitender Strompfad vorgesehen ist, welcher unabhängig vom aktiv abgeschirmten Magnetspulensystem mit einem Strom gespeist werden kann. Damit die zusätzlichen Strompfade das Streufeld der Magnetanordnung verbessern können ohne andere, sich auf die Funktion der Magnetanordnung nachteilig auswirkende Nebeneffekte aufzuweisen, müssen verschiedene Bedingungen an die Dimensionierung dieser Strompfade gestellt werden. Dies betrifft einerseits den, von den zusätzlichen Strompfaden im Arbeitsvolumen der Magnetanordnung erzeugten Feldbetrag, welcher betragsmäßig 5% des Feldbetrages des aktiv abgeschirmten supraleitenden Magnetspulensystems nicht überschreiten sollte. Andererseits muß sichergestellt werden, dass durch die in den zusätzlichen Strompfaden fließenden Ströme die Homogenität des Magnetfeldes der Magnetanordnung im Arbeitsvolumen nicht wesentlich verschlechtert wird. Da die Homogenität der Magnetanordnung insbesondere durch den Koeffizienten zweiter Ordnung der Polynomentwicklung des Magnetfeldes im Zentrum maßgeblich bestimmt wird, sollte der Beitrag der zusätzlichen Strompfade zum Koeffizienten zweiter Ordnung des Gesamtfeldes der Magnetanordnung im Vergleich zum entsprechenden Koeffizienten des aktiv abgeschirmten, supraleitenden Magnetspulensystems klein sein, beziehungsweise ein absolutes betragsmäßiges Maximum von $0.25 T/m^2$ nicht überschreiten. Diese Bedingungen werden auch von zusätzlichen, supraleitend geschlossenen Strompfaden gemäß dem zitierten Stand der Technik mindestens teilweise erfüllt.

In einer erfindungsgemäßen Ausführungsform der zusätzlichen, supraleitend geschlossenen Strompfade muß darüber hinaus gewährleistet sein, dass sie eine genügend große Flächenwindungszahl aufweisen, damit die in ihnen fließenden Ströme einen ausreichend großen Streufeldbeitrag, insbesondere ein magnetisches Dipolmoment, erzeugen können. Durch geeignete Wahl der in den einzelnen, zusätzlichen Strompfaden fließenden Ströme kann unter diesen Bedingungen im Betriebszustand der Anordnung mindestens ein Teil einer allfälligen, fertigungsbedingten Abweichung des magnetischen Dipolmomentes des aktiv abgeschirmten Magnetspulensystems von seinem Sollwert durch das Dipolmoment der in die zusätzlichen, supraleitend kurzgeschlossenen Strompfade fließenden Ströme kompensiert werden, ohne dass andere Eigenschaften des Magnetfeldes der Gesamtanordnung durch Feldbeiträge der zusätzlichen, supraleitend kurzgeschlossenen Strompfade wesentlich beeinträchtigt würden.

Der Vorteil einer erfindungsgemäßen Anordnung besteht darin, dass auch bei sehr gut aktiv abgeschirmten supraleitenden Magnetsystemen, deren Streufeld besonders stark auf Abweichungen der Designparameter der Magnetspulenanordnung von ihren Sollwerten reagiert, die theoretisch erreichbaren Streufeldlimiten eingehalten werden können, ohne dass kostspielige und aufwendige Maßnahmen getroffen werden müßten, um produktionstechnisch bedingte Abweichungen von den Designvorgaben zu verhindern. Dies erlaubt eine kostengünstigere Produktion, da während des Fertigungsprozesses keine zusätzlichen Vorkehrungen zur exakten Einhaltung der Wickeldaten gemäß Designvorgaben nötig sind und keine besonders eng tolerierten Drähte und Spulenkörper verwendet werden müssen. Besonders vorteilhaft an einer erfindungsgemäßen Anordnung ist, dass sie Streufeldgrenzwertüberschreitungen aufgrund von Abweichungen unterschiedlicher Designparameter des aktiv abgeschirmten Magnetspulensystems von ihren Sollwerten verhindern kann, ohne dass für jeden einzelnen Parameter eine spezielle Anordnung berechnet und konstruiert werden müßte.

Die erfindungsgemäße Magnetanordnung ist besonders dann vorteilhaft, wenn sich die magnetischen Dipolmomente der Teilspulensysteme des aktiv abgeschirmten Magnetspulensystems betragsmäßig um weniger als 1% des Betrags des magnetischen Dipolmoments des radial inneren Teilspulensystems unterscheiden. In diesem Fall sind die fertigungsbedingten Abweichungen der Dipolmomente der beiden Teilspulensysteme des aktiv abgeschirmten Magnetspulensystems in Relation zum Gesamtdipolmoment des Magnetspulensystems besonders groß. Dies führt zu großen Abweichungen des Gesamtdipolmoments des Magnetspulensystems von seinem theoretischen Wert schon aufgrund kleiner Abweichungen von Designparametern der Teilspulensysteme von ihren Sollwerten. Somit ist es insbesondere für solche aktiv abgeschirmte Magnetspulensysteme vorteilhaft, wenn eine erfindungsgemäße Vorrichtung in der Form zusätzlicher supraleitend kurzgeschlossener Strompfade zur Kompensation von Abweichungen des Streufeldes des Magnetspulensystems von seinem Sollwert vorhanden ist.

Besonders vorteilhaft ist auch eine Ausführungsform der erfindungsgemäßen Magnetanordnung, bei der die Magnetanordnung Teil einer Apparatur zur hochauflösenden Magnetresonanzspektroskopie ist. Da für solche Magnetanordnungen das radial innere Teilspulensystem aufgrund der für solche Apparaturen benötigten hohen Feldstärken im Allgemeinen ein sehr großes Dipolmoment aufweist, bringt der Einsatz aktiv abgeschirmter Magnetsysteme hier einen besonders großen Gewinn. In einer erfindungsgemäßen Anordnung ist gewährleistet, dass auch bei fertigungstechnisch bedingten Abweichungen des Magnetspulensystems von dessen Designvorgaben keine Streufeldüberhöhung auftritt, da eine solche aufgrund des typischerweise großen Dipolmomentes der Hauptspule in diesem Fall besonders unerwünscht wäre.

Besonders bevorzugt ist eine Ausführungsform der erfindungsgemäßen Magnetanordnung, bei der die Magnetanordnung ein weiteres supraleitendes Spulensystem umfaßt, welches in der Magnetanordnung als supraleitender Z2-Shim dient und durch dessen Beitrag zum Magnetfeld der Magnetanordnung der Koeffizient zweiter Ordnung der Polynomentwicklung des Magnetfeldes der Magnetanordnung im Betriebszustand weitgehend eliminiert wird. Dadurch, dass die Magnetanordnung zusätzlich einen Z2-Shim besitzt, können allfällige Verschlechterungen der Feldhomogenität der Magnetanordnung, wie sie durch nicht vollständig homogene Feldbeiträge zusätzlicher, supraleitend geschlossener Strompfade auftreten können, mindestens teilweise kompensiert werden. Dadurch wird erreicht, dass die zusätzlichen Strompfade nur eine Veränderung des Streufeldes außerhalb, nicht jedoch eine Verschlechterung der Feldhomogenität im Zentrum der Magnetanordnung bewirken.

Eine besonders bevorzugte Ausführungsform der erfindungsgemäßen Magnetanordnung zeichnet sich dadurch aus, dass mindestens einer der zusätzlichen, supraleitend kurzgeschlossenen Strompfade vom Magnetspulensystem insgesamt induktiv entkoppelt ist. Bei einer allfälligen induktiven Kopplung des Magnetspulensystems mit einem supraleitend kurzgeschlossenen Strompfad müsste nämlich dessen Schalter während des Ladevorganges regelmäßig geöffnet werden, um zu vermeiden, dass sich dieser Strompfad ungewünschter Weise induktiv auflädt. Außerdem wird für eine solche Anordnung auch beim Laden der zusätzlichen Strompfade auf ihren jeweiligen Betriebsstrom im aktiv abgeschirmten Magnetspulensystem keine Stromänderung induziert, welche sich in Form einer unerwünschten Feldverschiebung im Arbeitsvolumen bemerkbar machen würde.

Eine weitere vorteilhafte Ausführungsform der erfindungsgemäßen Magnetanordnung zeichnet sich dadurch aus, dass mindestens einer der zusätzlichen, supraleitend kurzgeschlossenen Strompfade Teil einer Vorrichtung ist, welche der Magnetanordnung zusätzliche Funktionalität verleiht, insbesondere, dass dieser Strompfad zur Kompensation von externen magnetischen Feldfluktuationen dient. Der Vorteil dieser Ausführungsform liegt darin, dass durch diese Doppelfunktionalität die gesamte Magnetanordnung kompakter gestaltet werden kann.

Eine weitere besonders bevorzugte Ausführungsform der erfindungsgemäßen Magnetanordnung zeichnet sich dadurch aus, dass mindestens einer der zusätzlichen, supraleitend kurzgeschlossenen Strompfade vom aktiv abgeschirmten Magnetspulensystem thermisch entkoppelt ist. Dies bewirkt, dass im Falle eines Quenchs im Magnetspulensystem die an diesen zusätzlichen Strompfad übertragene Wärmemenge mindestens kurzfristig zu klein ist, um in diesem zusätzlichen Strompfad einen Quench auszulösen. Dieser Umstand ist notwendig dafür, dass aufgrund der Änderung des magnetischen Flusses in der Anfangsphase des Quenchs des Magnetspulensystems ein Strom in den zusätzlichen noch supraleitenden Strompfad induziert werden kann, was eine Voraussetzung dafür ist, dass das Streufeld der Magnetanordnung auch während des Quenchs nicht überhöht wird.

Besonders bevorzugt ist auch eine Ausführungsform der erfindungsgemäßen Magnetanordnung, bei welcher mindestens einer der zusätzlichen, supraleitend geschlossenen Strompfade Magnetspulen umfaßt, welche einen Radius haben, der mindestens 90% des Radius der äußersten Spulen des aktiv abgeschirmten, supraleitenden Magnetspulensystems beträgt. Da dieser Strompfad eine große Fläche umschließt, erzeugt er ein beträchtliches magnetisches Dipolmoment, ohne dass er mit einem großen Strom gespeist werden müßte. Dies ist vorteilhaft, weil so der maximal fließende Strom in diesem Strompfad ohne Weiteres deutlich unter dem kritischen Strom, oberhalb welchem die Supraleitung zusammenbrechen würde, gehalten werden kann.

Eine weitere vorteilhafte Ausführungsform der erfindungsgemäßen Magnetanordnung zeichnet sich dadurch aus, dass mindestens einer der zusätzlichen, supraleitend geschlossenen Strompfade Spulen umfaßt, welche auf einem Spulenkörper gewickelt sind, der auch Spulen des äußeren Teilspulensystems des aktiv abgeschirmten, supraleitenden Magnetspulensystems als Träger dient. Dadurch wird erreicht, dass dieser zusätzliche Strompfad eine große Fläche umschließt und somit nur mit einem kleinen Strom gespeist werden muß, um ein magnetisches Dipolmoment zu erzeugen, welches einen ausreichenden Einfluß auf das Streufeld besitzt. Weil für diesen zusätzlichen Strompfad kein zusätzlicher Spulenkörper hergestellt werden muß, wird die Herstellung der Magnetanordnung günstiger.

Eine besonders bevorzugte Ausführungsform der erfindungsgemäßen Magnetanordnung zeichnet sich dadurch aus, dass die zusätzlichen, supraleitend geschlossenen Strompfade im Betriebszustand im Arbeitsvolumen der Magnetanordnung insgesamt einen vernachlässigbar kleinen Beitrag zum Magnetfeld der Magnetanordnung leisten. Dies hat den Vorteil, dass bei der Installation eines solchen Systems weniger Schritte notwendig sind, um einerseits das gewünschte Feld im Arbeitsvolumen und andererseits ein optimiertes Streufeld außerhalb der Magnetanordnung zu erreichen, da nach dem Setzen der Ströme in den zusätzlichen Strompfaden keine wesentliche Veränderung des Feldbetrages im Arbeitsvolumen auftritt.

Eine weitere vorteilhafte Ausführungsform der erfindungsgemäßen Magnetanordnung zeichnet sich dadurch aus, dass mindestens einer der zusätzlichen, supraleitend geschlossenen Strompfade im Betriebszustand bezüglich der Ebene, welche senkrecht zur $z$-Achse liegt und diese bei $z = 0$ schneidet, ein asymmetrisches Magnetfeld erzeugt. In einer solchen Ausführungsform können auch bezüglich dieser Ebene asymmetrische Abweichungen des Streufeldes der Magnetanordnung von seinem Sollverlauf korrigiert werden. Solche Streufeldverzerrungen können beispielsweise durch supraleitende Shimspulen in der Magnetanordnung hervorgerufen werden, sofern die Shimspulen einen Feldbeitrag leisten, der auf der $z$-Achse um $z = 0$ in ein Polynom in $z$ mit ungeraden Koeffizienten $Hn$ entwickelt werden kann.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

Fig. 1     einen schematischen Vertikalschnitt durch eine radiale Hälfte einer erfindungsgemäßen Magnetanordnung;

Fig. 2     ein Verdrahtungsschema einer erfindungsgemäßen Magnetanordnung.

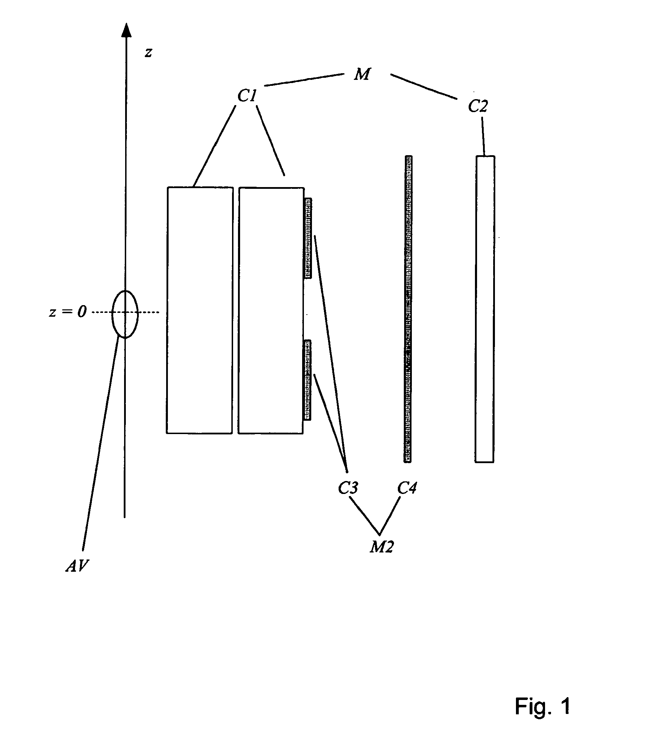

Anhand der Figur 1 wird eine erfindungsgemäße Magnetanordnung gezeigt, welche um ein Arbeitsvolumen $AV$ angeordnet ist und ein aktiv abgeschirmtes, supraleitendes Magnetspulensystem $M$ mit einem radial inneren und einem radial äußeren, koaxialen Teilspulensystem *C1* und *C2* sowie einen zusätzlichen, supraleitend geschlossenen Strompfad *P1* in Form eines weiteren Magnetspulensystems *M2* mit zwei supraleitenden Teilspulensystemen *C3* und *C4* umfaßt.

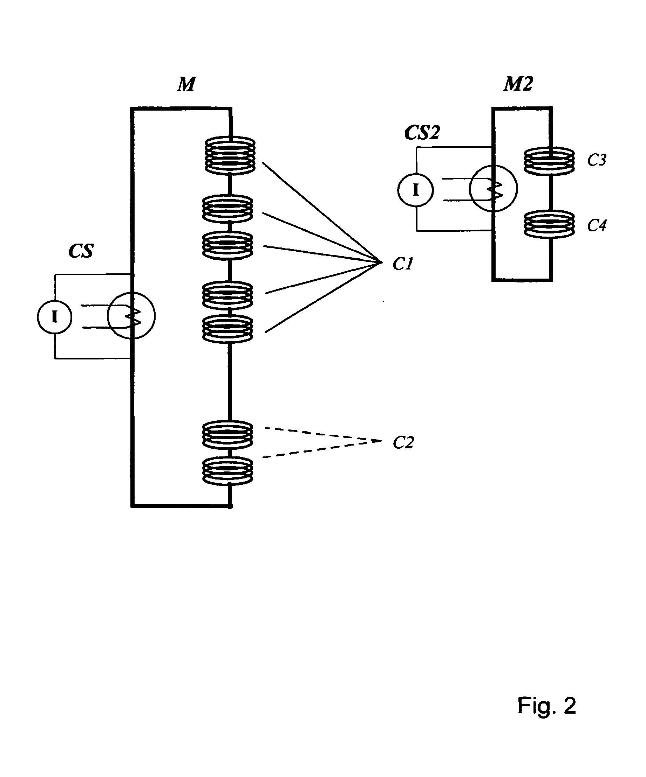

Figur 2 zeigt schematisch die Verdrahtung einer erfindungsgemäßen Magnetanordnung, insbesondere einen zusätzlichen, supraleitend geschlossenen und mit einer Stromspeisung *CS2* versehenen Strompfad *P1* in der Ausführungsform eines vom aktiv abgeschirmten, supraleitenden Magnetspulensystem *M* getrennten zusätzlichen Spulensystems *M2* mit zwei supraleitenden Teilspulensystemen *C3* und *C4*. Die Magnetspulensysteme *M* und *M2* können mit den Stromversorgungen *CS* beziehungsweise *CS2* auf voneinander unabhängige Betriebsströme geladen werden.

Im Folgenden wird die Erfindung anhand von zwei Ausführungsformen einer Magnetanordnung mit einem aktiv abgeschirmten, supraleitenden Magnetspulensystem erläutert, welche im Arbeitsvolumen *AV* je ein Magnetfeld der Stärke 9T erzeugen. Als Supraleitermaterial wird Niob-Titan eingesetzt. Die Magnetanordnung wird in einem Flüssighelium-Bad betrieben bei einer Temperatur von 4.2K.

Die erste Magnetanordnung (im Weiteren Ausführungsform "*V1*" genannt) umfaßt ein aktiv abgeschirmtes, supraleitendes Magnetspulensystem *M* gemäß dem aktuellen Stand der Technik. Ein radial inneres Teilspulensystem *C1* und ein radial äußeres Teilspulensystem *C2* sind Teil dieses Magnetspulensystems. Hierbei besteht *C1* aus zwei, direkt aufeinander gewickelten, konzentrischen und koaxialen Solenoidspulen *C1a* und *C1b,* welche die gleiche Polarität aufweisen, und *C2* besteht aus einer einzelnen, zu *C1* konzentrisch und koaxial angeordneten Solenoidspule mit zu *C1* entgegengesetzter Polarität. Der Betriebsstrom für dieses Magnetspulensystem beträgt 81.7A, die freie Innenbohrung hat einen Durchmesser von 70mm.

Mit der Variante *V1* wird eine erfindungsgemäße Variante (im Weiteren "*V2*" genannt) verglichen, welche neben dem Magnetspulensystem M einen zusätzlichen, supraleitend geschlossenen Strompfad *P1* in Form eines weiteren Spulensystems *M2* mit zwei in Serie miteinander verbundenen supraleitenden Teilspulensystemen *C3* und *C4* umfaßt. Im vorliegenden Beispiel ist das Magnetspulensystem M identisch mit demjenigen der Variante *V1, C3* besteht aus einer Helmholtzspule, welche direkt auf die äußerste Lage von *C2* gewickelt wurde und *C4* aus einer weiteren, radial zwischen den zwei Teilspulensystemen *C1* und *C2* angeordneten Solenoidspule.

Tabelle 1 zeigt die wichtigsten Merkmale der Spulensysteme *C1 (C1a* und *C1b)* und *C2* sowie von *C3* und *C4*.

**Tabelle 1**

|  | *C1a* | *C1b* | *C2* | *C3* | *C4* |
|---|---|---|---|---|---|
| *ri* [mm] | 38.0 | 58.5 | 222.0 | 102.2 | 147.5 |
| *ra* [mm] | 58.5 | 102.2 | 225.4 | 106.8 | 149.8 |
| *L* [mm] | 380 | 380 | 450 | 63.3 | 450 |
| *C* [mm] | 0 | 0 | 0 | $\pm$55.8 | 0 |
| *W* | 361 | 468 | 698 | 98 | 698 |
| *N* | 26 | 62 | 6 | 8 | 4 |
| *m** [m$^2$] | 673.4 | | -658.7 | -53.9 | 193.9 |
|  | 14.7 | | | 140.0 | |

In der Tabelle 1 bezeichnen:

*ri*      den Innenradius der Spule,

*ra*      den Außenradius der Spule,

*L*       die Länge der Solenoidspule beziehungsweise einer Teilspule der Helmholtzspule,

*C*       die axiale Position des Zentrums der Solenoidspule beziehungsweise einer Teilspule der Helmholtzspule,

*W*       die Anzahl Draht-Windungen auf jeder Lage der Solenoidspule beziehungsweise einer Teilspule der Helmholtzspule,

*N*       die Anzahl Drahtlagen der Solenoidspule beziehungsweise der Helmholtzspule,

$m^*$     das magnetische Dipolmoment pro Ampere Strom.

Der zusätzliche Strompfad $P1$ ist vom Magnetspulensystem $M$ induktiv entkoppelt und erzeugt im Zentrum der Magnetanordnung weder eine Veränderung des Feldbetrages noch des Koeffizienten zweiter Ordnung $H2$ der Polynomentwicklung des Magnetfeldes im Zentrum der Magnetanordnung. Pro Ampère Strom im zusätzlichen Strompfad $P1$ wird nur eine vernachlässigbare Änderung $\Delta H0$ = 9.2·10⁻⁶T des magnetischen Feldes und $\Delta H2$ = -1.7·10⁻⁴T/m² des Koeffizienten zweiter Ordnung erzeugt.

Im Folgenden soll nun für die Magnetanordnungen V1 beziehungsweise $V2$ der Einfluß von Abweichungen von den Designvorgaben in einzelnen Magnetspulen auf das Streufeld der Anordnung im Betriebszustand berechnet werden. Als Beispiel für eine mögliche Abweichung eines Designparameters von seinem Sollwert dient hier eine Zunahme der Drahtwindungen im Teilspulensystem $C2$ gegenüber dem theoretischen Wert aufgrund eines gegenüber seinem Sollwert verminderten Durchmessers des Supraleiterdrahtes.

Das Magnetspulensystem M weist ein Streufeld auf, welches beispielsweise durch die maximale Ausdehnung der 0.5mT Isofeldfläche charakterisiert werden kann. In einer Ausführung des Magnetspulensystems $M$ gemäß Designvorgaben beträgt diese Ausdehnung 0.63m in radialer und 1.09m in axialer Richtung. Wird nun beispielsweise im Teilspulensystem $C2$ ein Draht verwendet, welcher verglichen mit den spezifizierten Werten einen um 4% kleineren Durchmesser aufweist, so dass dieses Teilspulensystem 727 statt 698 Windungen pro Lage umfaßt, so wird die radiale Ausdehnung der 0.5mT Isofeldfläche für die Variante $V1$ deutlich vergrößert. Durch Laden des zusätzlichen Strompfades $P1$ mit einem Strom von 19.2A in der erfindungsgemäßen Magnetanordnung $V2$ wird die Abweichung des Streufeldes vom Sollwert theoretisch unter Berücksichtigung der tatsächlichen Windungszahlen weitgehend kompensiert. Eine weitere Möglichkeit, den optimalen Strom im Strompfad $P1$ zu bestimmen, besteht darin, das Streufeld des Magneten zu messen und den benötigten Kompensationsstrom experimentell festzulegen.

Tabelle 2 zeigt die resultierenden Dipolmomente im Betriebszustand und die Abmessungen der 0.5mT Isofeldfläche für die zwei Ausführungsformen $V1$ und $V2$ gemäß Designvorgaben sowie für einen um 4% zu dünnen Draht im Teilspulensystem $C2$.

**Tabelle 2**

|  | gemäß Design | Wickelabweichungen in C2 | |
|---|---|---|---|
|  | *V1 & V2* | *V1* | *V2* |
| *IP1* [A] | 0 | - | 19.2 |
| *R5G* [m] | 0.63 | 0.80 | 0.63 |
| *Z5G* [m] | 1.09 | 0.92 | 1.14 |
| *B63* [mT] | 0.50 | 1.26 | 0.49 |
| $m_{C1}$ [Am²] | 55051 | 55225 | 55225 |
| $m_{C2}$ [Am²] | -53850 | -56236 | -56236 |
| $m_M$ [Am²] | 1201 | -1011 | -1011 |
| $m_{p1}$ [Am²] | 0 | - | 2687 |

In der Tabelle 2 bezeichnen:

$IP1$     den im zusätzlichen Strompfad $P1$ fließenden Strom,

$R5G$     die maximale Ausdehnung der 0.5mT Isofeldfläche in radialer Richtung, gemessen ab der Magnetachse,

$Z5G$     die maximale Ausdehnung der 0.5mT Isofeldfläche in axialer Richtung, gemessen ab der Magnetmittelebene,

$B63$     den maximalen Betrag der Feldstärke der Magnetanordnung auf einer mit dem Magnetspulensystem koaxialen Zylinderfläche mit Radius 0.63m,

$m_{C1}$     das magnetische Dipolmoment des Teilspulensystems $C$1 im Betriebszustand,

$m_{C2}$     das magnetische Dipolmoment des Teilspulensystems $C$2 im Betriebszustand,

$m_M$ das magnetische Dipolmoment des Magnetspulensystems $M$ im Betriebszustand,

$m_{p1}$ das magnetische Dipolmoment des zusätzlichen Strompfades $P1$ im Betriebszustand.

Wie man den Werten aus der Tabelle 2 entnehmen kann, bewirkt die Abweichung der Wickeldaten von den Designvorgaben eine deutliche Änderung des magnetischen Dipolmomentes des Teilspulensystems $C2$. In der erfindungsgemäßen Ausführungsform $V2$ wird diese Änderung weitgehend durch das magnetische Dipolmoment, welches von dem in den zusätzlichen Strompfad $P1$ gespeisten Strom erzeugt wird, wieder wettgemacht, so dass ein gegenüber dem Design praktisch unverändertes Streufeld resultiert. Wie man ebenfalls der Tabelle 2 entnehmen kann, weist ein hinsichtlich minimaler radialer Ausdehnung der 0.5mT Isofeldfläche optimiertes Magnetspulensystem M kein minimales magnetisches Dipolmoment auf. Im Falle der angenommenen Windungszahlabweichungen im Teilspulensystem $C2$ resultiert für die Variante $V1$ ein im Vergleich mit den Designvorgaben betragsmäßig kleineres magnetisches Dipolmoment, die Ausdehnung der 0.5mT Isofeldfläche in radialer Richtung ist jedoch deutlich größer als gemäß Designvorgaben. In der erfindungsgemäßen Ausführungsform $V2$ wird durch den in den zusätzlichen Strompfad $P1$ gespeisten Strom die radiale Ausdehnung der 0.5mT Isofeldfläche wieder minimiert, obwohl das resultierende Gesamtdipolmoment dadurch betragsmäßig größer wird.

Der Bereich innerhalb des Abstandes $R5G$ von der Magnetachse muß typischerweise von magnetfeldempfindlichen Geräten und magnetischen Materialien freigehalten werden. Für eine Anordnung gemäß Designvorgaben beträgt dieser Abstand 0.63m. Es ist daher entscheidend, dass die Feldstärke von 0.5mT ab diesem Abstand von der Magnetachse auch dann nicht überschritten wird, wenn einzelne Spulenparameter Werte aufweisen, welche vom Sollwert abweichen. Diese Forderung wird in der Ausführungsform $V1$ nicht erfüllt. Das Streufeld kann im Abstand von 0.63m von der Magnetachse bis auf über das Doppelte des Designwertes von 0.5mT ansteigen und der Grenzwert von 0.5mT wird erst außerhalb eines Abstandes von 0.80m von der Magnetachse wieder unterschritten. Demgegenüber tritt in der erfindungsgemäßen Variante $V2$ keine Streufelderhöhung gegenüber den Designwerten auf.

Das Streufeld des Magnetspulensystems $M$ im obigen Beispiel ist hinsichtlich einer minimalen radialen Ausdehnung der 0.5mT Isofeldfläche optimiert. Aufgrund von fertigungsbedingten Abweichungen einzelner Spulenparameter von ihren Designvorgaben kann in einer Ausführung der Magnetanordnung aus obigem Beispiel gemäß dem bisherigen Stand der Technik eine Reduktion der axialen Ausdehnung der 0.5mT Isofeldfläche gegenüber dem Sollwert resultieren. Dies geht aber immer mit einer Vergrößerung der radialen Ausdehnung der 0.5mT Isofeldfläche einher (wie aus dem in der Tabelle 2 gezeigten Beispiel ersichtlich ist). In einer erfindungsgemäßen Ausführung der Magnetanordnung kann dagegen durch geeignete Wahl der in den zusätzlichen Strompfaden fließenden Ströme der Einfluß von fertigungsbedingten Abweichungen einzelner Spulenparameter von ihren Designvorgaben auf das Streufeld weitgehend eliminiert werden. Somit können unabhängig von fertigungsbedingten Schwankungen gewisser Spulenparameter die im Design angestrebten Streufeldwerte der Magnetanordnung immer eingehalten werden. Mit einer erfindungsgemäßen Magnetanordnung kann also - unabhängig von fertigungsbedingten Schwankungen gewisser Spulenparameter - erreicht werden, dass das Streufeld der Anordnung im Betriebszustand immer hinsichtlich jener Kriterien optimiert ist, hinsichtlich welcher auch das Streufeld des aktiv abgeschirmten Magnetspulensystems im Design optimiert wurde.

**Patentansprüche**

1. Magnetanordnung zur Erzeugung eines Magnetfeldes $(H)$ in Richtung einer $z$-Achse in einem auf der $z$-Achse um $z = 0$ angeordneten Arbeitsvolumen $(AV)$ mit einem aktiv abgeschirmten, supraleitenden Magnetspulensystem $(M)$ und mit mindestens einem, im Betriebszustand in sich supraleitend geschlossenen Strompfad $(P1, ..., Pn)$ eines weiteren Magnetspulensystems (M2), wobei das aktiv abgeschirmte, supraleitende Magnetspulensystem $(M)$ ein radial inneres Teilspulensystem $(C1)$ und ein radial äußeres Teilspulensystem $(C2)$ umfasst, welche zueinander koaxial angeordnet sind und deren magnetische Dipolmomente im Betriebszustand entgegengesetzte Vorzeichen aufweisen und sich betragsmäßig um $\Delta_m$ voneinander unterscheiden mit $|\Delta_m| < 2.5\%$ des Betrags des magnetischen Dipolmoments des radial inneren Teilspulensystems $(C1)$, und wobei das Magnetfeld $(H)$ der Magnetanordnung auf der $z$-Achse um $z = 0$ in ein Polynom in z mit den Koeffizienten $Hn$ entwickelt werden kann, und wobei die Magnetanordnung über eine externe Vorrichtung zur Speisung des mindestens einen Strompfades $(P1, ..., Pn)$ verfügt, so dass im Betriebszustand alle Strompfade $(P1, ..., Pn)$ mit je einem Strom $(IP1, ..., IPn)$ geladen sind, und wobei alle Strompfade $(P1, ...,Pn)$ im Betriebszustand im Arbeitsvolumen $(AV)$ der Magnetanordnung insgesamt einen Beitrag zum Magnetfeld $(H)$ der Magnetanordnung leisten, dessen Betrag kleiner ist als 5% des Feldbetrages des Magnetspulensystems $(M)$ im Betriebszustand,
**dadurch gekennzeichnet, dass**
zur Optimierung des Streufeldverlaufs außerhalb der Magnetanordnung der Betrag des magnetischen Dipolmomentes aller auf ihren jeweiligen Betriebsstrom $(IP1, ..., IPn)$ geladenen Strompfade $(P1, ..., Pn)$ insgesamt mindestens 0.1 % des Betrages des magnetischen Dipolmomentes des geladenen radial äußerten Teilspulensystems *(C2)* erreicht, und dass beim Laden aller Strompfade *(P1, ...,Pn)* auf ihren jeweiligen Betriebsstrom *(IP1, ..., IPn)* für die Veränderung $\Delta_{H2}$ des Koeffizienten zweiter Ordnung *(H2)* der Polynomentwicklung des Magnetfeldes *(H)* der Magnetanordnung gilt:

$$|\Delta_{H2}| < \max(0.25\,T/m^2,\ 0.9 \cdot |H2(M)|),$$

wobei *H2(M)* den Koeffizienten zweiter Ordnung der Polynomentwicklung des Magnetfeldes des aktiv abgeschirmten, supraleitenden Magnetspulensystems *(M)* im Betriebszustand bezeichnet.

**2.** Magnetanordnung nach Anspruch 1, **dadurch gekennzeichnet, dass** $|\Delta_m| < 1\%$ des Betrags des magnetischen Dipolmoments des radial inneren Teilspulensystems *(C1)* ist.

**3.** Magnetanordnung nach einem der vorhergehenden Ansprüche, **dadurch gekennzeichnet, dass** die Magnetanordnung Teil einer Apparatur zur hochauflösenden Magnetresonanzspektroskopie ist.

**4.** Magnetanordnung nach einem der vorhergehenden Ansprüche, **dadurch gekennzeichnet, dass** die Magnetanordnung ein weiteres supraleitendes Spulensystem umfasst, welches in der Magnetanordnung als supraleitender Z2-Shim dient und durch dessen Beitrag zum Magnetfeld (*H*) der Magnetanordnung der Koeffizient zweiter Ordnung *(H2)* der Polynomentwicklung des Magnetfeldes *(H)* der Magnetanordnung im Betriebszustand weitgehend eliminiert wird.

**5.** Magnetanordnung nach einem der vorhergehenden Ansprüche, **dadurch gekennzeichnet, dass** der mindestens eine Strompfad *(P1, ...,Pn)* vom aktiv abgeschirmten, supraleitenden Magnetspulensystem *(M)* weitgehend induktiv entkoppelst ist.

**6.** Magnetanordnung nach einem der vorhergehenden Ansprüche, **dadurch gekennzeichnet, dass** mindestens ein supraleitend kurzgeschlossener Strompfad *(P1, ..., Pn)* zusätzlich Teil einer Vorrichtung ist, welche im Betriebszustand in der Magnetanordnung zur Kompensation externer magnetischer Feldfluktuationen dient.

**7.** Magnetanordnung nach einem der vorhergehenden Ansprüche, **dadurch gekennzeichnet, dass** mindestens ein Strompfad *(P1, ..., Pn)* vom aktiv abgeschirmten, supraleitenden Magnetspulensystems *(M)* thermisch entkoppelt ist, vorzugsweise derart, dass die im Falle eines Quenchs des aktiv abgeschirmten, supraleitenden Magnetspulensystems (*M*) an diesen Strompfad übertragene Wärmemenge nicht mehr als fünfzig Prozent derjenigen Wärmemenge beträgt, welche zur Auslösung eines Quenchs in diesem Strompfad nötig ist.

**8.** Magnetanordnung nach einem der vorhergehenden Ansprüche, **dadurch gekennzeichnet, dass** mindestens ein Strompfad *(P1, ..., Pn)* Magnetspulen umfasst, welche einen Radius haben, der mindestens 90% des Radius der äußersten Spulen des aktiv abgeschirmten, supraleitenden Magnetspulensystems *(M)* beträgt.

**9.** Magnetanordnung nach einem der vorhergehenden Ansprüche, **dadurch gekennzeichnet, dass** mindestens ein Strompfad *(P1, ..., Pn)* Spulen umfasst, welche auf einem Spulenkörper gewickelt sind, der auch Spulen des radial äußeren Teilspulensystems *(C2)* des aktiv abgeschirmten, supraleitenden Magnetspulensystems *(M)* als Träger dient.

**10.** Magnetanordnung nach einem der vorhergehenden Ansprüche, **dadurch gekennzeichnet, dass** der mindestens eine Strompfad *(P1, ...,Pn)* im Betriebszustand im Arbeitsvolumen *(AV)* der Magnetanordnung insgesamt einen vernachlässigbar kleinen Beitrag zum Magnetfeld *(H)* der Magnetanordnung leisten.

**11.** Magnetanordnung nach einem der vorhergehenden Ansprüche, **dadurch gekennzeichnet, dass** mindestens ein Strompfad *(P1, ..., Pn)* im Betriebszustand bezüglich der Ebene, welche senkrecht zur *z*-Achse liegt und diese bei *z* = 0 schneidet, ein asymmetrisches Magnetfeld erzeugt.

**Claims**

1.  Magnet assembly for generating a magnetic field *(H)* in the direction of a z axis in a working volume *(AV)* disposed on the z axis about z = 0, comprising an actively shielded superconducting magnet coil system *(M)* and at least one current path *(P1, ..., Pn)* which is superconductingly closed in the operating state of yet another coil system *(M2)*, wherein the actively shielded superconducting magnet coil system *(M)* comprises a radially inner partial coil system *(C1)* and a radially outer partial coil system *(C2)* disposed coaxially with respect to each other and whose magnetic dipole moments in the operating state have opposite signs and differ by an amount of $\Delta_m$ with $|\Delta_m| < 2.5\%$ of the magnitude of the magnetic dipole moment of the radially inner partial coil system *(C1),* and wherein the magnetic field *(H)* of the magnet assembly can be expanded along the z axis about *z* = 0 in a polynomial in z having coefficients *Hn,* the magnet assembly having an external device for current supply of the at least one current path *(P1, ..., Pn)* such that the current paths *(P1, ..., Pn)* are each charged in the operating state with a respective current *(IP1, ..., IPn)* and wherein the entirety of the current paths *(P1, ...,Pn)* have an overall contribution to the magnetic field *(H)* of the magnet assembly in the operating state in the working volume *(AV)* of the magnet assembly of an amount which is less than 5% of the field contribution of the magnet coil system *(M)* in the operating state, **characterized in that**
    in order to optimize the fringe field behavior outside of the magnet assembly, the overall magnitude of magnetic dipole moments of the entirety of the current paths *(P1, ..., Pn)* charged to their respective operating currents *(IP1, ..., IPn)* is at least 0.1% of the magnitude of the magnetic dipole moment of the charged radially outer partial coil system *(C2),* wherein when charging each of the current paths *(P1, ...,Pn)* to their respective operating current *(IP1, ..., IPn)* the resulting change $\Delta_{H2}$ of the coefficient of second order *(H2)* of the polynomial expansion of the magnetic field *(H)* of the magnet assembly is given by:

$$|\, \Delta_{H2}\,| < \max (\, 0.25 \text{T/m}^2,\ 0.9 \cdot |\, H2(M)\,|\,),$$

    wherein *H2(M)* designates the coefficient of second order of the polynomial expansion of the magnetic field of the actively shielded superconducting magnet coil system *(M)* in the operating state.

2.  Magnet assembly according to claim 1, **characterized in that** $|\Delta_m| < 1\%$ of the magnitude of the magnetic dipole moment of the radially inner partial coil system *(C1).*

3.  Magnet assembly according to any one of the preceding claims, **characterized in that** the magnet assembly is part of an apparatus for high-resolution magnetic resonance spectroscopy.

4.  Magnet assembly according to any one of the preceding claims, **characterized in that** the magnet assembly comprises a further superconducting coil system which serves as superconducting Z2 shim in the magnet assembly and whose contribution to the magnetic field *(H)* of the magnet assembly largely eliminates the coefficient of second order *(H2)* of the polynomial expansion of the magnetic field *(H)* of the magnet assembly in the operating state.

5.  Magnet assembly according to any one of the preceding claims, **characterized in that** the at least one current path *(P1, ...,Pn)* is largely inductively decoupled from the actively shielded superconducting magnet coil system *(M).*

6.  Magnet assembly according to any one of the preceding claims, **characterized in that** at least one superconductingly short-circuited current path *(P1, ..., Pn)* is also part of a device, which compensates for external magnetic field fluctuations in the operating state of the magnet assembly.

7.  Magnet assembly according to any one of the preceding claims, **characterized in that** at least one current path *(P1, ..., Pn)* is thermally decoupled from the actively shielded superconducting magnet coil system *(M)*, preferably such that the amount of heat transferred to this current path in case of a quench of the actively shielded superconducting magnet coil system *(M)* is not more than fifty percent of the amount of heat required to trigger a quench in this current path.

8.  Magnet assembly according to any one of the preceding claims, **characterized in that** at least one current path *(P1, ..., Pn)* comprises magnet coils having a radius which is at least 90% of the radius of the outermost coils of the actively shielded superconducting magnet coil system *(M).*

9. Magnet assembly according to any one of the preceding claims, **characterized in that** at least one current path *(P1, ..., Pn)* comprises coils which are wound on a coil former which also serves as a carrier for coils of the radially outer partial coil system *(C2)* of the actively shielded superconducting magnet coil system *(M)*.

10. Magnet assembly according to any one of the preceding claims, **characterized in that** the overall contribution of the at least one current path *(P1, ...,Pn)* to the magnetic field *(H)* of the magnet assembly in the operating state within the working volume *(AV)* of the magnet assembly is negligibly small.

11. Magnet assembly according to any one of the preceding claims, **characterized in that** at least one current path *(P1, ..., Pn)* generates a magnetic field in the operating state which is asymmetrical relative to a plane which is perpendicular to the z axis and intersects same at z = 0.

**Revendications**

1. Arrangement magnétique destiné à générer un champ magnétique *(H)* en direction d'un axe z dans un volume de travail *(AV)* disposé sur l'axe *z* autour de *z* = 0, avec un système de bobines magnétiques supraconductrices blindé activement *(M)* et avec au moins un circuit de courant *(P1,..., Pn),* fermé sur lui-même de manière supraconductrice en condition de fonctionnement, d'un autre système de bobines magnétiques *(M2),* le système de bobines magnétiques supraconductrices blindé activement *(M)* comprenant un sous-système de bobines radialement intérieur *(C1)* et un sous-système de bobines radialement extérieur *(C2),* lesquels sont disposés coaxialement l'un à l'autre et dont les moments dipolaires magnétiques présentent, en condition de fonctionnement, des signes opposés et diffèrent l'un de l'autre d'une valeur $\Delta_m$, avec $|\Delta_m| < 2,5\%$ de la valeur du moment dipolaire magnétique du sous-système de bobines radialement intérieur *(C1),* et le champ magnétique *(H)* de l'arrangement magnétique sur l'axe z autour de z = 0 pouvant être développé en un polynôme en z avec les coefficients *Hn,* et l'arrangement magnétique comportant un dispositif externe pour alimenter ledit au moins un circuit de courant *(P1, ..., Pn)* de manière qu'en condition de fonctionnement tous les circuits de courant *(P1, ..., Pn)* soient chargés chacun par un courant *(IP1, ..., IPn),* et tous les circuits de courant *(P1, ..., Pn)* apportant au total, en condition de fonctionnement, dans le volume de travail *(AV)* de l'arrangement magnétique une contribution au champ magnétique *(H)* de l'arrangement magnétique dont la valeur est inférieure à 5 % de la valeur du champ du système de bobines magnétiques *(M)* en condition de fonctionnement,
**caractérisé en ce que**
pour optimiser l'allure du champ de fuite à l'extérieur de l'arrangement magnétique, la valeur du moment dipolaire magnétique de tous les circuits de courant *(P1, ..., Pn)* chargés à leurs courants de fonctionnement respectifs *(IP1, ..., IPn)* atteint au total au moins 0,1 % de la valeur du moment dipolaire magnétique du sous-système de bobines radialement extérieur *(C2)* chargé, et que lors de la charge de tous les circuits de courant *(P1, ..., Pn)* à leurs courants de fonctionnement respectifs (IPI, ..., IPn), la variation $\Delta_{H2}$ du coefficient de deuxième ordre *(H2)* du développement polynomial du champ magnétique *(H)* de l'arrangement magnétique s'écrit :

$$|\Delta_{H2}| < \max(0{,}25\ \mathrm{T/m}^2,\ 0{,}9 \cdot |H2(M)|),$$

où *H2(M)* désigne le coefficient de deuxième ordre du développement polynomial du champ magnétique du système de bobines magnétiques supraconductrices blindé activement *(M)* en condition de fonctionnement.

2. Arrangement magnétique selon la revendication 1, **caractérisé en ce que** $|\Delta_m| < 1\%$ de la valeur du moment dipolaire magnétique du sous-système de bobines radialement intérieur *(C1).*

3. Arrangement magnétique selon l'une des revendications précédentes, **caractérisé en ce que** l'arrangement magnétique fait partie d'un appareillage pour la spectroscopie par résonance magnétique à haute résolution.

4. Arrangement magnétique selon l'une des revendications précédentes, **caractérisé en ce que** l'arrangement magnétique comprend un autre système de bobines supraconductrices qui sert, dans l'arrangement magnétique, de shim Z2 supraconducteur et dont la contribution au champ magnétique *(H)* de l'arrangement magnétique élimine en grande partie le coefficient de deuxième ordre *(H*2*)* du développement polynomial du champ magnétique *(H)* de l'arrangement magnétique en condition de fonctionnement.

**5.** Arrangement magnétique selon l'une des revendications précédentes, **caractérisé en ce que** ledit au moins un circuit de courant *(P1, ..., Pn)* est en grande partie découplé inductivement du système de bobines magnétiques supraconductrices blindé activement (*M*).

**6.** Arrangement magnétique selon l'une des revendications précédentes, **caractérisé en ce qu'**au moins un circuit de courant (*P1,..., Pn*) en court-circuit supraconducteur fait en plus partie d'un dispositif qui, en condition de fonctionnement, sert dans l'arrangement magnétique à compenser les fluctuations externes de champ magnétique.

**7.** Arrangement magnétique selon l'une des revendications précédentes, **caractérisé en ce qu'**au moins un circuit de courant (*P1,..., Pn*) est découplé thermiquement du système de bobines magnétiques supraconductrices blindé activement *(M),* de préférence de manière que la quantité de chaleur transmise à ce circuit de courant en cas de quench du système de bobines magnétiques supraconductrices blindé activement *(M)* ne s'élève pas à plus de cinquante pour cent de la quantité de chaleur qui est nécessaire pour déclencher un quench dans ce circuit de courant.

**8.** Arrangement magnétique selon l'une des revendications précédentes, **caractérisé en ce qu'**au moins un circuit de courant (*P1, ..., Pn*) comprend des bobines magnétiques qui ont un rayon qui est au moins égal à 90 % du rayon des bobines les plus extérieures du système de bobines magnétiques supraconductrices blindé activement *(M).*

**9.** Arrangement magnétique selon l'une des revendications précédentes, **caractérisé en ce qu'**au moins un circuit de courant (*P1*, ..., *Pn*) comprend des bobines qui sont enroulées sur une carcasse de bobine qui sert aussi de support aux bobines du sous-système de bobines radialement extérieur *(C2)* du système de bobines magnétiques supraconductrices blindé activement *(M).*

**10.** Arrangement magnétique selon l'une des revendications précédentes, **caractérisé en ce que** ledit au moins un circuit de courant (*P1,..., Pn*) apporte au total, en condition de fonctionnement, dans le volume de travail *(AV)* de l'arrangement magnétique une contribution négligeable au champ magnétique *(H)* de l'arrangement magnétique.

**11.** Arrangement magnétique selon l'une des revendications précédentes, **caractérisé en ce qu'**au moins un circuit de courant (*P1,..., Pn*) génère, en condition de fonctionnement, un champ magnétique asymétrique par rapport au plan qui est perpendiculaire à l'axe $z$ et coupe celui-ci en $z = 0$.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6265960 B
- WO 0052490 A